Europäisches Patentamt

European Patent Office

Office européen des brevets

(19)

(11) **EP 1 184 975 A1**

(12) **EUROPEAN PATENT APPLICATION**
published in accordance with Art. 158(3) EPC

(43) Date of publication:
06.03.2002 Bulletin 2002/10

(51) Int Cl.⁷: **H03G 3/20**

(21) Application number: **01917682.5**

(22) Date of filing: **30.03.2001**

(86) International application number:
**PCT/JP01/02728**

(87) International publication number:
**WO 01/73945 (04.10.2001 Gazette 2001/40)**

(84) Designated Contracting States:
**AT BE CH CY DE DK ES FI FR GB GR IE IT LI LU
MC NL PT SE TR**
Designated Extension States:
**AL LT LV MK RO SI**

(30) Priority: **31.03.2000 JP 2000098515**

(71) Applicant: **MATSUSHITA ELECTRIC INDUSTRIAL
CO., LTD.
Kadoma-shi, Osaka 571-8501 (JP)**

(72) Inventor: **KAJITA, Kuniyuki
Yokohama-shi, Kanagawa 236-0042 (JP)**

(74) Representative:
**Grünecker, Kinkeldey, Stockmair &
Schwanhäusser Anwaltssozietät
Maximilianstrasse 58
80538 München (DE)**

(54) **GAIN CONTROL DEVICE**

(57)    A convergence coefficient determination section 104 compares an average value calculated by an average value calculator 103 with a preset threshold value, and determines a convergence coefficient. A gain coefficient determination section 106 determines a control gain based on the aforementioned convergence coefficient and the aforementioned average value. A gain/voltage converter 107 converts the gain coefficient to a voltage to obtain a voltage control value. A GCA 101 amplifies a received signal in accordance with the voltage control value after it has undergone digital conversion.

FIG. 1

## EP 1 184 975 A1

**Description**

Technical Field

The present invention relates to a gain control apparatus and gain control method in CDMA (Code Division Multiple Access) mobile communications.

Background Art

In mobile communications, automatic gain control (hereinafter referred to as "AGC") is generally carried out for the purpose of improving precision when converting a received analog signal to a digital signal. This automatic gain control performs feedback control of the gain of an amplifier installed in the stage before an A/D converter so that the power level of an input signal to the A/D converter converges at a preset convergence target value. This convergence target value is determined beforehand according to the characteristics of the A/D converter, and A/D conversion can be performed with high precision by controlling an amplifier gain so that the power level of input signals to the A/D converter is held in the vicinity of this convergence target value.

A conventional gain control apparatus that performs AGC monitors the received level of a received signal, calculates a voltage control value based on the difference value between the received level of the monitored received signal and the target value, and performs feedback control of the amplifier gain in accordance with the calculated voltage control value. The voltage control value for controlling an amplifier gain is obtained by multiplying the logarithm of the aforementioned difference value by a predetermined convergence coefficient, and further adding the result of this multiplication to the voltage control value used in the previous control operation. This convergence coefficient is multiplied by in order to converge the power level of an output signal to the target value, and has a value of not less than 0 and less than 1.

However, in conventional AGC there is a problem in that, due to that fact that the convergence coefficient is set as a value not less than 0 and less than 1, if, for example, the received level of a received signal varies greatly because of shadowing at the exit of a tunnel or in the shadow of a building, or the like, or high-speed fading, or frequency switching in Compressed Mode, it is necessary to bring the received level close to the target value rapidly, but with conventional control it takes a long time for the received level to approach the target value, and during this period A/D conversion cannot be performed with high precision and the call state degrades. This problem can be solved by setting the convergence coefficient to 1 or greater when the received level of the received signal fluctuates greatly, but if this is done, a problem arises in that the output signal power level diverges or oscillates, and does not converge to the target value.

Disclosure of Invention

It is an object of the present invention to provide a gain control apparatus that enables the received level of a received signal that is obtained by digital conversion to be converged rapidly to a convergence target value without causing it to diverge or oscillate.

In arriving at the present invention, the inventors noted that, even when a received level fluctuates greatly due to fading, etc., the monitored received level is reflected only in calculation of the difference value between an A/D converter output signal and its target value, and is not reflected in the convergence coefficient.

That is to say, the object of the present invention is achieved by selecting as appropriate from among a plurality of convergence coefficients a suitable convergence coefficient for converging an A/D converter input signal at high speed to a target value, and obtaining a voltage control value using the difference value between the A/D converter output signal and its target value, and the selected convergence coefficient.

More specifically, a gain control apparatus according to the present invention calculates a voltage control value based on the logarithm of the difference value between an A/D converter output signal and its target value (received level monitoring result), and controls an amplifier gain in accordance with the calculated voltage control value. The voltage control value for controlling an amplifier gain is calculated by converting a gain coefficient obtained by multiplying the aforementioned difference value logarithm by a convergence coefficient determined based on the received level, and further adding that multiplication result to the voltage control value used in the previous control operation, to a voltage value, using a predetermined conversion equation. This convergence coefficient is multiplied by in order to converge the output signal power level to a target value, and is determined by comparison with a predetermined threshold value.

2

Brief Description of Drawings

FIG.1 is a block diagram showing the configuration of a gain control apparatus according to Embodiment 1 of the present invention;

FIG.2 is a block diagram showing the configuration of an average value calculator provided in the gain control apparatus according to Embodiment 1 of the present invention;

FIG.3 is a block diagram showing the configuration of the average value calculator provided in a gain control apparatus according to Embodiment 1 of the present invention;

FIG.4 is a block diagram showing the configuration of the average value calculator provided in a gain control apparatus according to Embodiment 1 of the present invention;

FIG.5 is a block diagram showing the configuration of the average value calculator provided in a gain control apparatus according to Embodiment 1 of the present invention;

FIG.6 is a block diagram showing the configuration of a gain control apparatus according to Embodiment 2 of the present invention; and

FIG.7 is a block diagram showing the configuration of a gain control apparatus according to Embodiment 3 of the present invention.

Best Mode for Carrying out the Invention

With reference now to the accompanying drawings, embodiments of the present invention will be explained in detail below.

(Embodiment 1)

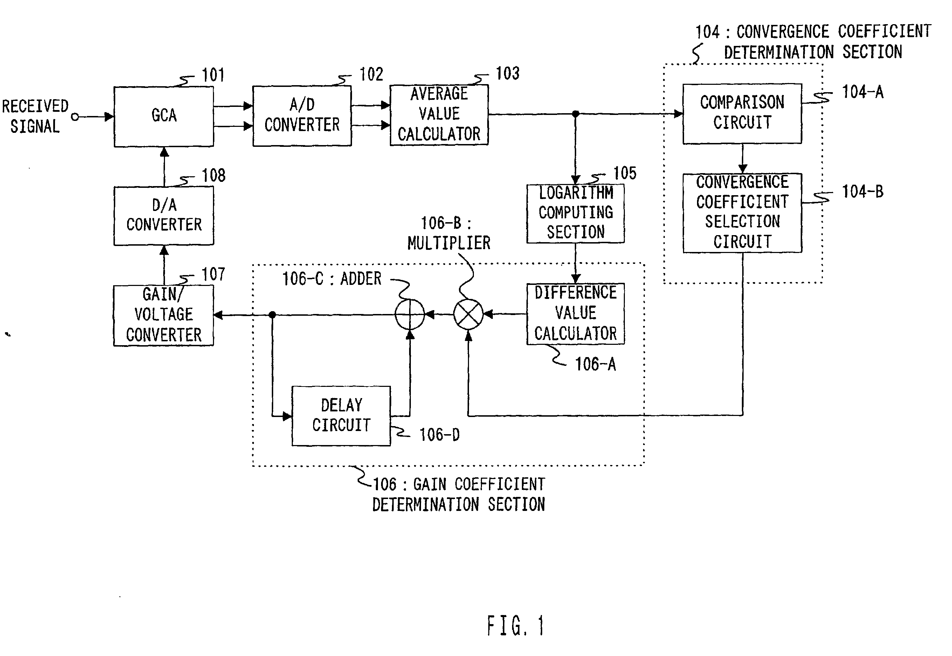

FIG.1 is a block diagram showing the configuration of a gain control apparatus according to Embodiment 1 of the present invention. As shown in this diagram, the gain control apparatus comprises a gain control amplifier 101, an A/D converter 102, an average value calculator 103, a convergence coefficient determination section 104, a logarithm computing section 105, a gain coefficient determination section 106, a gain/voltage converter 107, and a D/A converter 108. The convergence coefficient determination section 104 comprises a comparison circuit 104-A and a convergence coefficient selection circuit 104-B, and the gain coefficient determination section 106 comprises a difference value calculator 106-A, a multiplier 106-B, an adder 106-C, and a delay circuit 106-D.

This gain control apparatus controls a gain control amplifier 101 by calculating a voltage control value for every symbol of a received signal.

The gain control amplifier (hereinafter referred to as "GCA") 101 amplifies a received signal based on a voltage control value output from the D/A converter 108 described later herein. The A/D converter 102 converts an analog received signal amplified by the GCA 101 into a digital received signal, and outputs it to the average value calculator 103. The average value calculator 103 calculates the average value of, for example, 0.5 symbol of a digital signal output from the A/D converter 102, and outputs the calculated average value to the comparison circuit 104-A provided in the convergence coefficient determination section 104 and to the logarithm computing section 105.

In the comparison circuit 104-A, a threshold value A1 and a threshold value A2 have been set. The comparison circuit 104-A compares an average value output from the average value calculator 103 with the threshold value A1 and the threshold value A2, and outputs a signal indicating the result of this comparison to the convergence coefficient selection circuit 104-B.

In the convergence coefficient selection circuit 104-B, a convergence coefficient B1 and a convergence coefficient B2 have been set beforehand according to (Equation 1) and (Equation 2) below.

$$0 \leqq [\text{convergence coefficient B1}] \leqq 1 \qquad \text{(Equation 1)}$$

$$1 \leqq [\text{convergence coefficient B2}] \leqq [\text{convergence coefficient upper limit value}] \qquad \text{(Equation 2)}$$

The convergence coefficient upper limit value is a value calculated based on the number of bits of the A/D converter 102, the convergence target value, threshold value A1, etc. Convergence coefficient B1 and convergence coefficient B2 are calculated by deriving the input/output characteristics when an excessive step signal is input to a gain control apparatus according to this embodiment, deriving converge conditions taking into consideration the amplitude of that step signal, sampling interval, control period, averaging length, threshold value A1, threshold value A2, and convergence target value, and the number of bits of the A/D converter 102, and determining the convergence coefficient value and conditions that make the convergence coefficient variable. The aforementioned control period is the period for updating the voltage control value, and in this embodiment has a length of one symbol. The averaging length is the interval in which a received signal is averaged, and in this embodiment has a length of 0.5 symbol. Aforementioned threshold value A2 is a threshold value for judging whether or not the aforementioned average value has overflowed (been clipped) in the A/D converter 102, aforementioned threshold value A1 is a threshold value for judging whether or not the aforementioned average value has underflowed (been clipped to 0) in the A/D converter 102, and the aforementioned convergence target value is the input level when the dynamic range of the A/D converter 102 is set for 1.0. Overflow (clipping) means that the number of bits of the A/D converter 102 exceeds a preset number of bits, and underflow (clipping to 0) means that, because the A/D converter 102 input signal level is low, the output signal is identified as 0.

The logarithm computing section 105 performs an operation for logarithmic conversion on an average value output from the average value calculator 103, and the logarithm-converted average value is output to the difference value calculator 106-A provided in the gain coefficient determination section 106.

In the difference value calculator 106-A, a value to be used as the target of a logarithm-converted average value (hereinafter referred to as "target value") has been set beforehand. The difference value calculator 106-A calculates the difference (hereinafter referred to as "difference value") between the logarithm-converted average value output from the logarithm computing section 105 (reference value) and the target value, and outputs this to the multiplier 106-B. That is, the difference value calculator 106-A detects the difference between the reference value and target value. The multiplier 106-B multiplies the difference value output from the difference value calculator 106-A by the convergence coefficient output from the convergence coefficient selection circuit 104-B, and outputs the result of the multiplication to the adder 106-C. The adder 106-C adds together the multiplication result from the multiplier 106-B and the gain coefficient of the last symbol output from the delay circuit 106-D, and calculates the gain coefficient for the current control timing. The calculated gain coefficient is output to the gain/voltage converter 107 and delay circuit 106-D. The delay circuit 106-D delays the gain coefficient output from the adder 106-C by one symbol and outputs it to the adder 106-C.

The gain/voltage converter 107 converts the gain coefficient output from the adder 106-C using a predetermined conversion equation to generate a voltage control value, and outputs the generated voltage control value to the D/A converter 108. The D/A converter 108 performs D/A conversion of the voltage control value from the gain/voltage converter 107, and outputs the resulting signal to the GCA 101.

Next, the operation of a gain control apparatus that has the above-described configuration will be explained.

A received signal is amplified using an amplification factor determined on the basis of an analog-converted voltage control value from the D/A converter 108 in the GCA 101, and is output to the A/D converter 102. In the A/D converter 102, the amplified received signal undergoes digital conversion and is output to the average value calculator 103. In the average value calculator 103, the average value for 0.5 symbol of the digital-converted received signal is calculated, and the calculated average value is output to the convergence coefficient determination section 104 and logarithm computing section 105.

In the convergence coefficient determination section 104, a threshold value A1 and a threshold value A2 have been set beforehand in the comparison circuit 104-A, and a convergence coefficient B1 and a convergence coefficient B2 have been set beforehand in the convergence coefficient selection circuit 104-B. In this comparison circuit 104-A, the average value output from the average value calculator 103 is compared with the threshold values, and a signal indicating the result of that determination is output to the convergence coefficient selection circuit 104-B. More specifically, the convergence coefficient selection circuit 104-B judges whether or not the average value from the average value calculator 103 satisfies (Equation 3) below.

$$[\text{Threshold value A1}] < [\text{average value}] < [\text{threshold value A2}] \qquad (\text{Equation 3})$$

In the convergence coefficient selection circuit 104-B, convergence coefficient B1 is selected if the signal indicating the result of the judgment output from the comparison circuit 104-A indicates that (Equation 3) above is satisfied, and convergence coefficient B2 is selected if that signal indicates that (Equation 3) is not satisfied. The convergence coefficient selected in this way is output to the multiplier 106-B provided in the gain coefficient determination section 106.

In the logarithm computing section 105, the average value output from the average value calculator 103 undergoes logarithmic conversion, and the logarithm-converted average value is output to the difference value calculator 106-A.

In the difference value calculator 106-A, a difference value, which is the difference between the logarithm-converted average value output from the logarithm computing section 105 and the preset target value, is calculated, and is output to the multiplier 106-B. In the multiplier 106-B, the difference value output from the difference value calculator 106-A is multiplied by the convergence coefficient output from the convergence coefficient selection circuit 104-B, and the result of this multiplication is output to the adder 106-C. In the adder 106-C, the multiplication result from the multiplier 106-B is added to the gain coefficient of the last symbol output from the delay circuit 106-D, and the gain coefficient for the current control timing is calculated. The calculated gain coefficient is output to the gain/voltage converter 107 and delay circuit 106-D. In the delay circuit 106-D, the gain coefficient output from the adder 106-C undergoes one-symbol delay processing and is output to the adder 106-C.

In the gain/voltage converter 107, the gain coefficient from the gain coefficient determination section 106 is converted according to (Equation 4) below, and a voltage control value is generated.

$$[\text{Voltage control value}] = 2^{10}/(50-(-50)) \times [\text{gain coefficient}] + 512 \qquad \text{(Equation 4)}$$

The generated voltage control value is output to the D/A converter 108.

In the D/A converter 108, the voltage control value output from the gain/voltage converter 107 undergoes analog conversion according to (Equation 5) below, and is output to the GCA 101.

$$[\text{D/A converter 108 output voltage}] = (2.0-1.0) \times [\text{voltage control value}]/2^{10} + 1.0 \qquad \text{(Equation 5)}$$

A gain control apparatus according to this embodiment enables optimal parameters to be set by performing theoretical calculations. More specifically, by setting parameters in the ranges below under the conditions shown below, it is believed that, even when the fluctuation levels of $\pm 80$dB occur on the communication path, the received signal level can be converged to within $\pm 2.0$ dB with respect to the convergence target value during processing of 10 symbols.

(Conditions)

Number of bits in A/D converter = 6
Assumed step signal amplitude = 20 to 80 dB
Sampling interval = 3.84 MHz
Control period = 1 symbol
Averaging length = 0.3 to 0.9 symbols

(Parameter set values)

Threshold value A1 = [minimum value in A/D converter]
Threshold value A2

= [maximum value in A/D converter] $\times$ 0.8 Convergence target value
= [maximum value in A/D converter] $\times$ 0.3 Convergence coefficient B1 = 0.3 to 0.5
Convergence coefficient B2 = 1.0 to 2.8

The above conditions vary due to various causes, and can be derived theoretically. Parameters that are set according to variations in conditions, also, are changed as appropriate according to those variations in conditions. For example, if the control period is set as one slot, it is probable that convergence toward the convergence target value will be performed while processing is performed for 10 slots.

Thus, according to a gain control apparatus of this embodiment, different convergence coefficients are selected according to the average value of the output signal of the A/D converter 102, and therefore the power level of the A/D converter output signal can be converged at high speed to the target value. That is, if the output signal of the A/D converter 102 is very far from the target value, a large convergence coefficient is selected and the voltage control value is varied greatly, thereby enabling the target value to be approached at high speed. On the other hand, if the output signal of the A/D converter 102 is close to the target value, a small convergence coefficient is selected and the voltage control value is varied to a small extent, and consequently the power level does not diverge or oscillate, and can converge toward the target value at high speed.

For a gain control apparatus according to this embodiment, a case has been described where the voltage control value is calculated and the GCA 101 controlled every symbol, but the present invention is not limited to this, and control may be performed at any interval. For example, control may be performed every slot.

Also, in this embodiment, a case has been described where two threshold values, threshold value A1 and threshold value A2, have been set in the comparison circuit 104-A, but the present invention is not limited to this, and it is possible for only threshold value A1 to be set. In this case, the comparison circuit 104-A judges whether or not the average value from the average value calculator 103 satisfies (Equation 6) below.

$$[\text{Threshold value A1}] < [\text{average value}] \qquad\qquad (\text{Equation 6})$$

The convergence coefficient selection circuit 104-B selects convergence coefficient B1 if the signal indicating the result of the judgment from the comparison circuit 104-A indicates that (Equation 6) above is satisfied, or selects convergence coefficient B2 if that signal indicates that (Equation 6) is not satisfied, and sets the convergence coefficient.

It is also possible for only threshold value A2 to be set in the comparison circuit 104-A. In this case, the comparison circuit 104-A judges whether or not the average value from the average value calculator 103 satisfies (Equation 7) below.

$$[\text{Average value}] < [\text{threshold value A2}] \qquad\qquad (\text{Equation 7})$$

The convergence coefficient selection circuit 104-B selects convergence coefficient B1 if the signal indicating the result of the judgment from the comparison circuit 104-A indicates that (Equation 7) above is satisfied, or selects convergence coefficient B2 if that signal indicates that (Equation 7) is not satisfied, and sets the convergence coefficient.

Moreover, three or more threshold values may be set in the comparison circuit 104-A.

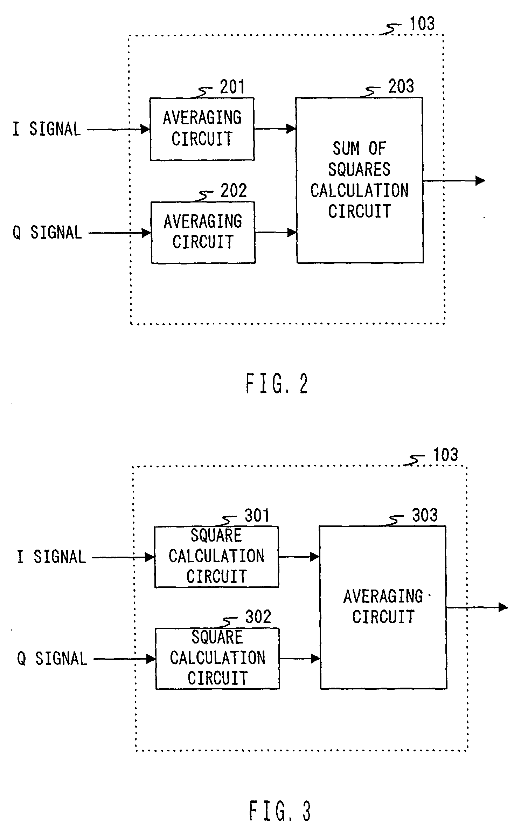

An average value calculator 103 provided in a gain control apparatus according to this embodiment has the configuration shown in FIG.2. FIG.2 is a block diagram showing a configuration of the average value calculator 103 provided in a gain control apparatus according to this embodiment.

As shown in FIG.2, the average value calculator 103 comprises averaging circuits 201 and 202, and a sum of squares calculation circuit 203. Averaging circuit 201 calculates the average value for 0.5 symbol of the in-phase component (I component) of a digital-converted received signal output from the A/D converter 102, and outputs this to the sum of squares calculation circuit 203. Averaging circuit 202 calculates the average value for 0.5 symbol of the quadrature phase component (Q component) of a digital-converted received signal output from the A/D converter 102, and outputs this to the sum of squares calculation circuit 203. The sum of squares calculation circuit 203 squares the average value of each component output from averaging circuit 201 and averaging circuit 202, and obtains the sum of these squared respective component average values. The section 203 then outputs the sum of the squared respective component average values to the convergence coefficient determination section 104 and logarithm computing section 105 as the average value of the output from the A/D converter 102.

Thus, according to an average value calculator 103 with the above-described configuration, by performing squaring operations in the sum of squares calculation circuit 203 after performing averaging operations in averaging circuits 201 and 202, the number of multiplications can be reduced compared to the case where squaring operations are performed first, and therefore the amount of processing involved in carrying out gain control can be reduced. Also, by keeping the number of squaring operations small compared to the case where squaring operations are performed first, overflow occurring in squaring operations can be reduced, enabling average values to be calculated with high precision.

The average value calculator 103 may also have the configuration shown in FIG.3. FIG.3 is a block diagram showing a configuration of the average value calculator 103 provided in a gain control apparatus according'to this embodiment.

As shown in FIG.3, the average value calculator 103 comprises square calculation circuits 301 and 302, and an averaging circuit 303. Square calculation circuit 301 squares the in-phase component (I component) of a digital-converted received signal output from the A/D converter 102, and outputs the result to the averaging circuit 303. Square calculation circuit 302 squares the quadrature phase component (Q component) of a digital-converted received signal output from the A/D converter 102, and outputs the result to the averaging circuit 303. The averaging circuit 303 calculates the average value of the squares of each component output from square calculation circuit 301 and square calculation circuit 302, and then outputs the calculated average value of the square values to the convergence coefficient determination section 104 and logarithm computing section 105 as the average value of the output from the A/D converter 102.

Thus, according to an average value calculator 103 with the above-described configuration, by calculating the average value in the averaging circuit 303 after performing squaring operations in square calculation circuits 301 and 302, noise can be suppressed to a greater extent than when average values are calculated first, and therefore average values can be calculated with high precision.

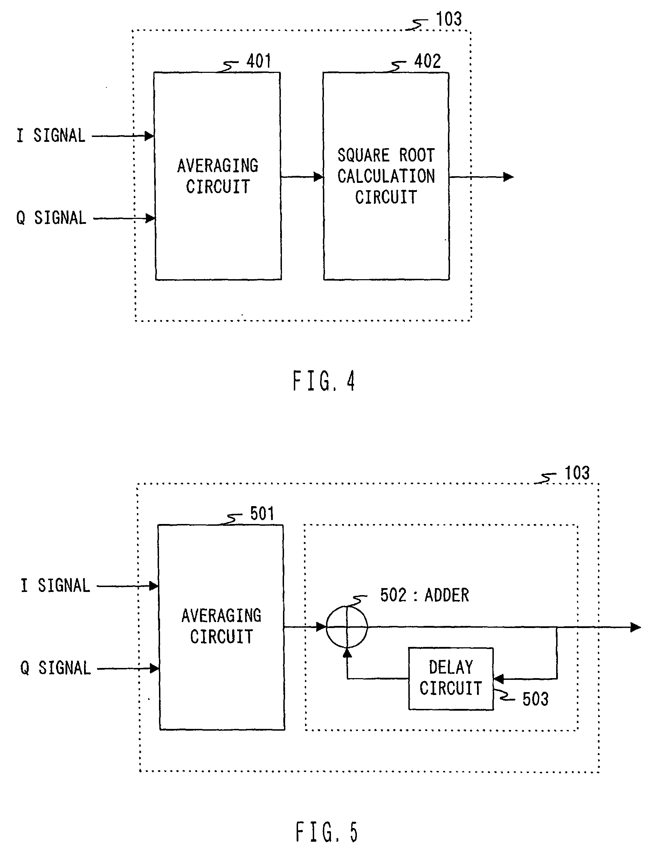

The average value calculator 103 may also have the configuration shown in FIG.4. FIG.4 is a block diagram showing a configuration of the average value calculator 103 provided in a gain control apparatus according to this embodiment.

As shown in FIG.4, the average value calculator 103 comprises an averaging circuit 401 and a square root calculation circuit 402. The averaging circuit 401 calculates the average values of the in-phase component (I component) and the quadrature phase component (Q component) of a digital-converted received signal output from the A/D converter 102, and outputs the result to the square root calculation circuit 402. The square root calculation circuit 402 calculates the square root of the average value of each component output from the averaging circuit 401, and then outputs the calculated square root to the convergence coefficient determination section 104 and logarithm computing section 105 as the average value of the output from the A/D converter 102.

Thus, according to an average value calculator 103 with the above-described configuration, the number of bits required to represent an average value can be reduced by obtaining the square root of an average value in the square root calculation circuit 402, enabling the hardware scale to be reduced.

The average value calculator 103 may also have the configuration shown in FIG.5. FIG.5 is a block diagram showing a configuration of the average value calculator 103 provided in a gain control apparatus according to this embodiment.

As shown in FIG.5, the average value calculator 103 comprises an averaging circuit 501, an adder 502, and a delay circuit 503. The averaging circuit 501 calculates the average values of the in-phase component (I component) and the quadrature phase component (Q component) of a digital-converted received signal output from the A/D converter 102, and outputs the result to the adder 502. The adder 502 adds together the average value output from the averaging circuit 501 and the average value of the last symbol output from the delay circuit 503, and then outputs the value resulting from the addition to the convergence coefficient determination section 104 and logarithm computing section 105 as the average value of the output from the A/D converter 102.

Thus, according to an average value calculator 103 with the above-described configuration, by adding the average value at the previous processing timing to the average value for the current control timing to obtain the average value of the output from the A/D converter 102, it is possible to calculate the average value for a long interval without causing delay due to average value calculation processing, thereby enabling gain control to be performed at high speed even when large fluctuations of a received level occur due to high-speed fading, etc.

(Embodiment 2)

A gain control apparatus according to Embodiment 2 detects a difference value between the received level of a received signal and its target value, calculates a voltage control value based on the result of this detection, and controls an amplifier gain in accordance with the calculated voltage control value. The voltage control value for controlling an amplifier gain is calculated by multiplying the logarithm of the aforementioned difference value by a convergence coefficient determined based on the received signal received level, then adding that multiplication result to the voltage control value used in the previous control operation to obtain the gain coefficient, and converting the gain coefficient thus obtained to a voltage value. This convergence coefficient is determined by comparing the number of samples that have caused overflow or underflow in digital conversion with a predetermined threshold value.

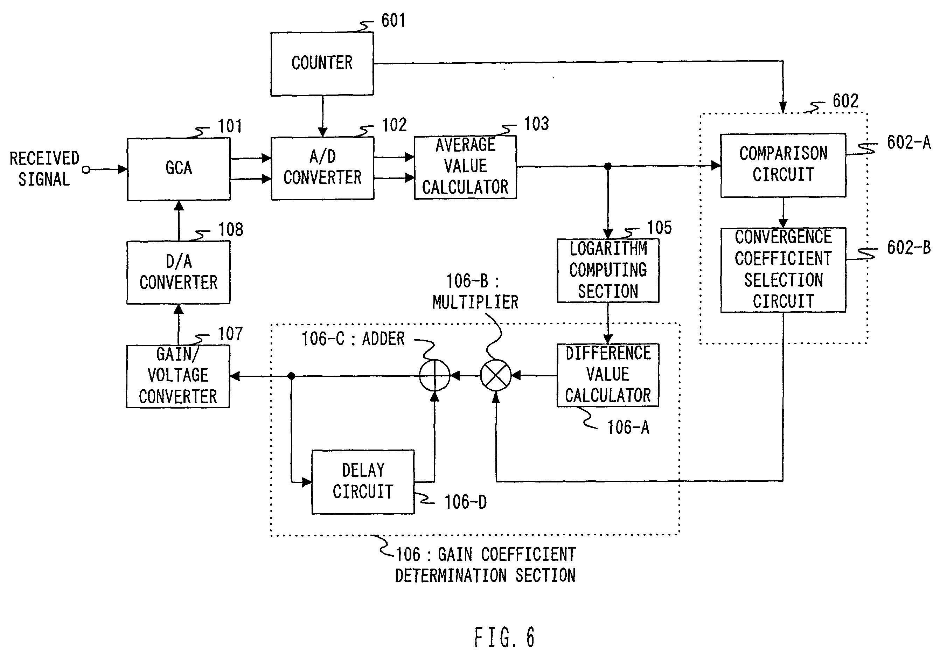

That is to say, Embodiment 2 differs from Embodiment 1 in that the convergence coefficient is determined based on the number of samples that have caused overflow or underflow in digital conversion. FIG.6 is a block diagram showing the configuration of a gain control apparatus according to Embodiment 2 of the present invention. Parts in FIG.6 6 identical to those in FIG.1 are assigned the same reference numerals as in FIG.1 and their detailed explanations are omitted.

The gain control apparatus shown in FIG.6 comprises a counter 601 for counting the number of bits for which overflow occurs and the number of bits for which underflow occurs in A/D conversion of an input signal amplified by the GCA 101, and a convergence coefficient determination section 602 for determining a convergence coefficient based on the output signal of the counter 601. The convergence coefficient determination section 602 comprises a comparison circuit 602-A and a convergence coefficient selection circuit 602-B.

In a gain control apparatus with the above-described configuration, a received signal amplified by the GCA 101 undergoes digital conversion by the A/D converter 102. The counter 601 counts the number of bits for which overflow occurs and the number of bits for which underflow occurs in a fixed interval when digital conversion is performed by the A/D converter 102, and outputs the total of the respective counted numbers of bits to the comparison circuit 602-A provided in the convergence coefficient determination section 602.

In the comparison circuit 602-A, a threshold value A3 has been set. The comparison circuit 602-A compares the total output from the counter 601 with threshold value A3. More specifically, the comparison circuit 602-A judges whether or not the total from the counter 601 satisfies (Equation 8) below.

$$\text{Total} < [\text{threshold value A3}] \qquad \text{(Equation 8)}$$

The comparison circuit 602-A outputs a signal indicating the result of the judgment to the convergence coefficient selection circuit 602-B.

A convergence coefficient B1 and convergence coefficient B2 have been set beforehand in the convergence coefficient selection circuit 602-B. These convergence coefficients are of the same kind as in Embodiment 1. In the convergence coefficient selection circuit 602-B, convergence coefficient B1 is selected if the signal indicating the result of the judgment from the comparison circuit 602-A indicates that (Equation 8) above is satisfied, and convergence coefficient B2 is selected if that signal indicates that (Equation 8) is not satisfied. The convergence coefficient selected in this way is output to the difference value calculator 106-A provided in the gain coefficient determination section 106.

Thus, according to a gain control apparatus of this embodiment, different convergence coefficients are selected according to the number of samples that overflow or underflow during digital conversion by the A/D converter 102, and therefore the power level of the A/D converter output signal can be converged at high speed to the target value. That is, if the output signal of the A/D converter 102 is very far from the target value, a large convergence coefficient is selected and the voltage control value is varied greatly, thereby enabling the target value to be approached at high speed. On the other hand, if the output signal of the A/D converter 102 is close to the target value, a small convergence coefficient is selected and the voltage control value is varied to a small extent, thereby enabling convergence toward the target value at high speed without unnecessarily moving back and forth either side of the target value.

(Embodiment 3)

A gain control apparatus according to Embodiment 3 detects a difference value between the received level of a received signal and its target value, calculates a voltage control value based on the result of this detection, and controls an amplifier gain in accordance with the calculated voltage control value. The voltage control value for controlling an amplifier gain is calculated by multiplying the logarithm of the aforementioned difference value by a convergence coefficient determined based on the received signal received level, then adding that multiplication result to the voltage control value used in the previous control operation to obtain the gain coefficient, and converting the gain coefficient thus obtained to a voltage value. This convergence coefficient is determined by comparing the received level of a received signal with a predetermined threshold value.

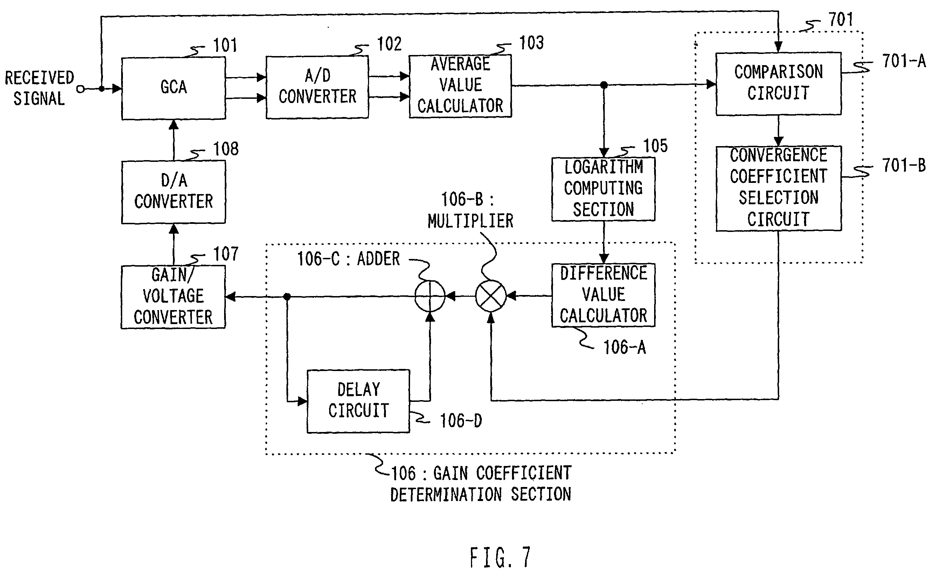

That is to say, Embodiment 3 differs from Embodiment 1 in that the convergence coefficient is determined by comparing directly the power level of a received signal with a threshold value. FIG.7 is a block diagram showing the configuration of a gain control apparatus according to Embodiment 3 of the present invention. Parts in FIG.7 identical to those in FIG. 1 are assigned the same reference numerals as in FIG.1 and their detailed explanations are omitted.

The gain control apparatus shown in FIG.7 comprises a convergence coefficient determination section 701 for determining a convergence coefficient based on the received signal level. The convergence coefficient determination section 701 comprises a comparison circuit 701-A and a convergence coefficient selection circuit 701-B. The received level mentioned here denotes any one of SIR (Signal to Interference Ratio), RSCP, RSSI, EC/I0, BER (Bit Error Ratio), or BLER.

In a gain control apparatus with the above-described configuration, a received signal is output to the GCA 101 and comparison circuit 701-A. In the comparison circuit 701-A, a threshold value A4 has been set. The comparison circuit 701-A compares the received signal level with threshold value A4. More specifically, the comparison circuit 701-A judges whether or not the received signal level satisfies (Equation 9) below.

$$[\text{Threshold value A4}] < [\text{received signal level}] \qquad \text{(Equation 9)}$$

The comparison circuit 701-A then outputs a signal indicating the result of the judgment to the convergence coefficient selection circuit 701-B.

A convergence coefficient B1 and convergence coefficient B2 have been set beforehand in the convergence coefficient selection circuit 701-B. These convergence coefficients are of the same kind as in Embodiment 1. In the convergence coefficient selection circuit 701-B, convergence coefficient B1 is selected if the signal indicating the result of the judgment from the comparison circuit 701-A indicates that (Equation 9) above is satisfied, and convergence coefficient B2 is selected if that signal indicates that (Equation 9) is not satisfied. The convergence coefficient selected in this way is output to the difference value calculator 106-A provided in the gain coefficient determination section 106.

Thus, according to a gain control apparatus of this embodiment, different convergence coefficients are selected according to the received signal level, and therefore the power level of the A/D converter 102 output signal can be converged at high speed to the target value. That is, if the output signal of the A/D converter 102 is very far from the target value, a large convergence coefficient is selected and the voltage control value is varied greatly, thereby enabling the target value to be approached at high speed. On the other hand, if the output signal of the A/D converter 102 is close to the target value, a small convergence coefficient is selected and the voltage control value is varied to a small extent, thereby enabling convergence toward the target value at high speed without unnecessarily moving back and forth either side of the target value.

As described above, according to the present invention, a convergence coefficient suitable for high-speed AGC is selected based on the received level of a received signal, and consequently it is possible to provide a gain control apparatus that enables the power level of a received signal which is obtained by digital conversion to be converged rapidly to a convergence target value without causing it to diverge or oscillate, even at the time high-speed fading or frequency switching in Compressed Mode.

This application is based on Japanese Patent Application No.2000-098515 filed on March 31, 2000, entire content of which is expressly incorporated by reference herein.

Industrial Applicability

The present invention is suitable for use in the field of a gain control apparatus and gain control method in CDMA (Code Division Multiple Access) mobile communications.

**Claims**

1. A gain control apparatus comprising:

   convergence coefficient determining means for determining a convergence coefficient based on a received level of a received signal;
   detecting means for detecting a difference value between a reference value obtained using the received signal and a preset target value;
   voltage control value calculating means for calculating a voltage control value based on a detection result of said detecting means and the convergence coefficient; and
   amplifying means for amplifying the received signal in accordance with the voltage control value calculated by said voltage control value calculating means.

2. The gain control apparatus according to claim 1, further comprising:

   average value calculating means for calculating an average value of the received level of the received signal,

   wherein said convergence coefficient determining means determines the convergence coefficient based on the average value from said average value calculating means.

3. The gain control apparatus according to claim 1, further comprising:

   A/D converting means for performing digital conversion of the received signal,

   wherein said convergence coefficient determining means counts the digitally converted samples where the number of bits set in said A/D converting means is exceeded and counts the digitally converted samples for which a level of an input signal approximates to 0, and determines a convergence coefficient based on the counted number of samples.

4. The gain control apparatus according to claim 1, wherein said convergence coefficient determining means determines the convergence coefficient by comparing the received level of the received signal with a preset threshold value.

5. The gain control apparatus according to claim 2, wherein said convergence coefficient determining means determines the convergence coefficient by comparing the average value calculated by said average value calculating means with a preset threshold value.

6. The gain control apparatus according to claim 3, wherein said convergence coefficient determining means determines the convergence coefficient by comparing the counted number of samples with a preset threshold value.

7. The gain control apparatus according to claim 1, wherein said voltage control value calculating means multiplies the detection result of said detecting means by the convergence coefficient determined by said convergence coefficient determining means and adds to the multiplication result the voltage control value used at the previous control timing to calculate a new voltage control value.

8. The gain control apparatus according to claim 2, wherein said average value calculating means calculates an in-phase average value which is an average value of an in-phase component of the received signal and a quadrature average value which is an average value of a quadrature phase component of the received signal respectively, and squares each of the in-phase average value and the quadrature average value to add.

9. The gain control apparatus according to claim 2, wherein said average value calculating means calculates an average value of a value obtained by squaring an in-phase component of the received signal and a value obtained by squaring a quadrature phase component of the received signal.

10. The gain control apparatus according to claim 2, wherein said average value calculating means calculates an average value for a fixed interval of the received signal, and calculates a square root of the calculated average value.

11. The gain control apparatus according to claim 2, wherein said average value calculating means calculates an average value of the received signal, and adds the calculated average value and a previous average value.

12. A communication terminal apparatus provided with a gain control apparatus, said gain control apparatus comprising:

convergence coefficient determining means for determining a convergence coefficient based on a received level of a received signal;
detecting means for detecting a difference value between a reference value obtained using the received signal and a preset target value;
voltage control value calculating means for calculating a voltage control value based on a detection result of said detecting means and the convergence coefficient; and
amplifying means for amplifying the received signal in accordance with the voltage control value calculated by said voltage control value calculating means.

13. A base station apparatus provided with a gain control apparatus, said gain control apparatus comprising:

convergence coefficient determining means for determining the convergence coefficient based on the received level of a received signal;
detecting means for detecting a difference value between the reference value obtained using the received signal and a preset target value;
voltage control value calculating means for calculating a voltage control value based on a detection result of said detecting means and the convergence coefficient; and
amplifying means for amplifying the received signal in accordance with the voltage control value calculated by said voltage control value calculating means.

14. A gain control method comprising the steps of:

determining a convergence coefficient based on a received level of a received signal;
detecting a difference value between a reference value obtained using said received signal and a preset target value;
calculating a voltage control value based on a detection result and the convergence coefficient; and
amplifying the received signal in accordance with the calculated voltage control value.

EP 1 184 975 A1

FIG. 1

103

201

I SIGNAL → AVERAGING CIRCUIT →

203

Q SIGNAL → AVERAGING CIRCUIT →

202

SUM OF SQUARES CALCULATION CIRCUIT →

FIG. 2

103

301

I SIGNAL → SQUARE CALCULATION CIRCUIT →

303

Q SIGNAL → SQUARE CALCULATION CIRCUIT →

302

AVERAGING CIRCUIT →

FIG. 3

103

401

402

I SIGNAL →

Q SIGNAL →

AVERAGING
CIRCUIT

SQUARE ROOT
CALCULATION
CIRCUIT

→

FIG. 4

103

501

I SIGNAL →

Q SIGNAL →

AVERAGING
CIRCUIT

502 : ADDER

DELAY
CIRCUIT

503

FIG. 5

FIG. 6

EP 1 184 975 A1

FIG. 7

## INTERNATIONAL SEARCH REPORT

| International application No. |
|---|
| PCT/JP01/02728 |

**A. CLASSIFICATION OF SUBJECT MATTER**
Int.Cl$^7$  H03G 3/20

According to International Patent Classification (IPC) or to both national classification and IPC

**B. FIELDS SEARCHED**

Minimum documentation searched (classification system followed by classification symbols)
Int.Cl$^7$  H03G 3/20-3/34

Documentation searched other than minimum documentation to the extent that such documents are included in the fields searched
Jitsuyo Shinan Koho          1922-1966    Toroku Jitsuyo Shinan Koho   1994-2001
Kokai Jitsuyo Shinan Koho    1971-2001    Jitsuyo Shinan Toroku Koho   1996-2001

Electronic data base consulted during the international search (name of data base and, where practicable, search terms used)
WPI/L, [?CDMA?*?AGC?]

**C. DOCUMENTS CONSIDERED TO BE RELEVANT**

| Category* | Citation of document, with indication, where appropriate, of the relevant passages | Relevant to claim No. |
|---|---|---|
| X | JP, 11-289231, A (NEC Kansai, Ltd.), 19 October, 1999 (19.10.99), | 1,2 |
| Y | Full text; all drawings   (Family: none) | 4-11,12,13,14 |
| Y | JP, 5-160653, A (Yamaha Corporation), 25 June, 1993 (25.06.93), Par. Nos. [0002] to [0005]; Fig. 10, 11  (Family: none) | 4-11,12,13,14 |

☐ Further documents are listed in the continuation of Box C.   ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier document but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 02 July, 2001 (02.07.01) | 10 July, 2001 (10.07.01) |

| Name and mailing address of the ISA/ | Authorized officer |
|---|---|
| Japanese Patent Office | |
| Facsimile No. | Telephone No. |

Form PCT/ISA/210 (second sheet) (July 1992)